(19) Europäisches Patentamt
European Patent Office
Office européen des brevets

(11) **EP 1 560 334 B1**

(12) **FASCICULE DE BREVET EUROPEEN**

(45) Date de publication et mention
de la délivrance du brevet:
**21.10.2009 Bulletin 2009/43**

(51) Int Cl.:
*H03K 23/40* *(2006.01)*      *H03K 23/48* *(2006.01)*

(21) Numéro de dépôt: **05100257.4**

(22) Date de dépôt: **17.01.2005**

(54) **Diviseur de fréquence**

Frequenzteiler

Frequency divider

(84) Etats contractants désignés:
**AT BE BG CH CY CZ DE DK EE ES FI FR GB GR HU IE IS IT LI LT LU MC NL PL PT RO SE SI SK TR**

(30) Priorité: **20.01.2004 FR 0400496**

(43) Date de publication de la demande:
**03.08.2005 Bulletin 2005/31**

(73) Titulaire: **Thales**
**92200 Neuilly Sur Seine (FR)**

(72) Inventeurs:
• **De Gouy, Jean-Luc,**
**THALES Intellectual Property**
**94117 CX Arcueil (FR)**
• **Gabet, Pascal,**
**THALES Intellectual Property**
**94117 CX Arcueil (FR)**

(74) Mandataire: **Lucas, Laurent Jacques et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
• **PATENT ABSTRACTS OF JAPAN vol. 1998, no. 03, 27 février 1998 (1998-02-27) & JP 09 289445 A (SHARP CORP), 4 novembre 1997 (1997-11-04)**
• **PATENT ABSTRACTS OF JAPAN vol. 013, no. 421 (E-822), 19 septembre 1989 (1989-09-19) -& JP 01 157616 A (FUJITSU LTD), 20 juin 1989 (1989-06-20)**
• **PATENT ABSTRACTS OF JAPAN vol. 1999, no. 07, 31 mars 1999 (1999-03-31) & JP 09 107284 A (HE HOLDINGS INC DBA HUGHES ELECTRON), 22 avril 1997 (1997-04-22)**

EP 1 560 334 B1

**Description**

L'invention concerne un dispositif de division de fréquence à au moins 3 rangs.

Elle s'applique, par exemple, dans le domaine de la synthèse de fréquence comme diviseur de tête pour une chaîne de division à rangs fractionnaires.

Les diviseurs de tête connus de l'art antérieur sont généralement des diviseurs à 2 rangs de division consécutifs.

L'invention concerne un dispositif pour diviser une fréquence $F_e$. Il est caractérisé en ce qu'il comporte au moins les éléments suivants :

o trois bascules ($U_1$, $U_2$, $U_3$), chacune des bascules recevant la fréquence $F_e$ à diviser, tout chemin de rebouclage entre une sortie d'une bascule et son entrée ou l'entrée des autres bascules comportent un seul multiplexeur ($M_1$, $M_2$, $M_3$), et en ce que
o l'une des bascules commande le chargement de toutes les bascules ($U_1$, $U_2$, $U_3$) pendant une période de $F_e$.

Un multiplexeur comporte par exemple 2 entrées, 1 bit de sélection, 1 sortie et en ce qu'il est intégré à une bascule.

Le dispositif peut comporter 2 latchs ($U_4$, $U_5$) et 2 multiplexeurs ($M_4$, $M_5$), recevant respectivement les entrées INC1 et INC2 du diviseur. Le multiplexeur peut être intégré à une bascule.

Application à un diviseur à 3 rangs de division 2/3/4.

L'invention présente notamment les avantages suivants : sa fréquence de fonctionnement est maximale, car les chemins de rebouclage entre une sortie de bascule D et son entrée ou l'entrée d'une autre bascule D sont minimaux en termes de nombre de couches logiques. Ces chemins ne comportent, en fonctionnement normal, un seul multiplexeur. Le multiplexeur est intégré ou intégrable à la bascule D en fonction de la technologie.

D'autres caractéristiques et avantages de la présente invention apparaîtront mieux à la lecture de la description donnée à titre illustratif et nullement limitatif annexé des figures qui représentent :

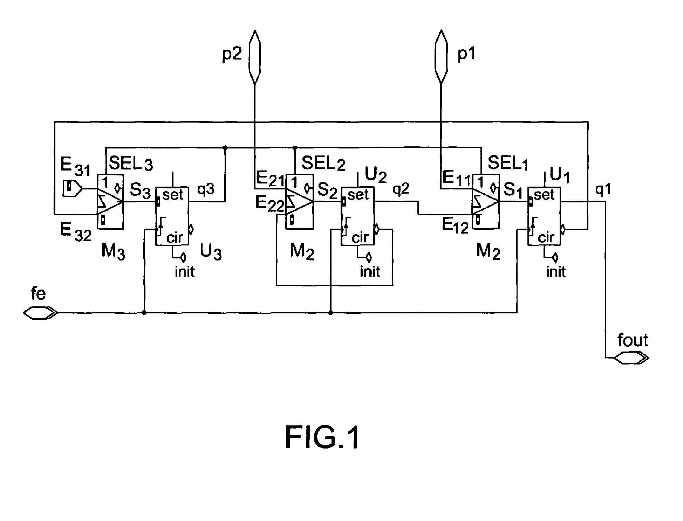

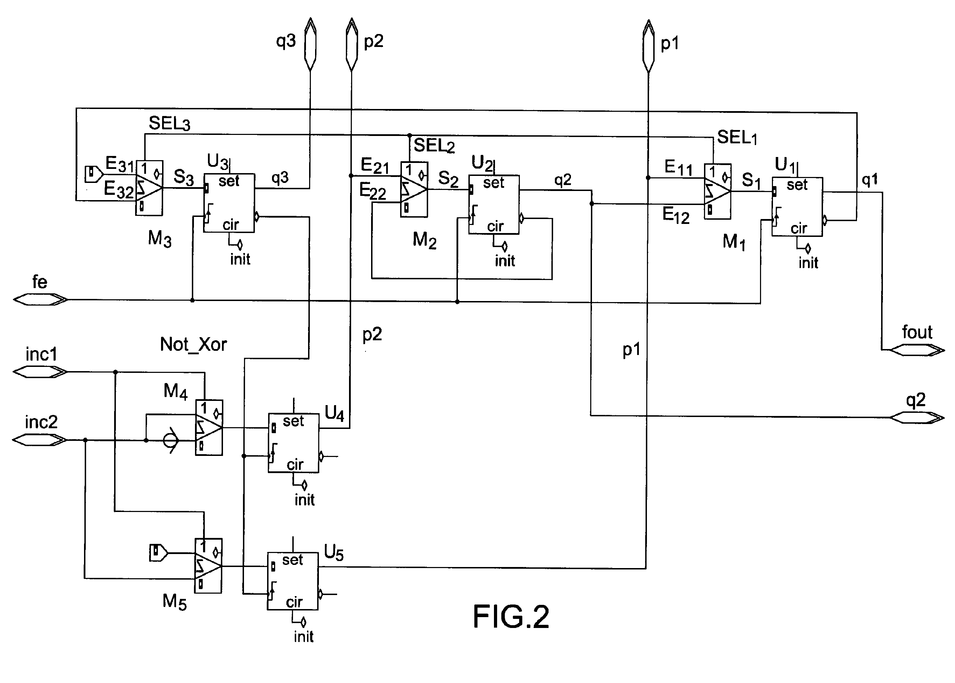

o La figure 1 un exemple de diviseur de fréquence divisant par les rangs 2, 3, 4,
o La figure 2 une variante de réalisation du diviseur de la figure 1.

Afin de mieux comprendre le principe mis en oeuvre dans le diviseur de fréquence selon l'invention, l'exemple qui suit concerne un diviseur à 3 rangs. Le principe s'applique aussi pour des diviseurs de fréquence à plus de 3 rangs, 4, 5, etc.

La figure 1 schématise un diviseur de fréquence divisant par 3 rangs, les rangs 2, 3 et 4, une fréquence $F_e$. Le choix entre les trois rangs de division est effectué au moyen d'un bus de commande composé de 2 bits référencés P1 et P2.

Il comporte, par exemple, 3 bascules D référencées $U_1$, $U_2$, $U_3$ dont les sorties sont notées Q1, Q2 et Q3. Q1 est la sortie du diviseur. Les signaux d'entrée P1 et P2 permettent de commander le rang de division de ce diviseur. Ce schéma est optimum en terme de fréquence de fonctionnement, car tout chemin de rebouclage entre une sortie Q, $\overline{Q}$ d'une bascule D et son entrée ou l'entrée d'une autre bascule D, comporte, en fonctionnement normal, un seul multiplexeur $M_1$, $M_2$, $M_3$ qui est généralement intégré ou intégrable à la bascule D dans la plupart des technologies. Un multiplexeur comporte par exemple 2 entrées $E_{i1}$, $E_{i2}$, 1 bit de sélection SELi et 1 sortie Si, avec i =1, 2, 3.

Toute bascule ayant une sortie qui mémorise la valeur de l'entrée à l'instant de la transition d'horloge (front d'horloge positif ou négatif) peut aussi être utilisée en remplacement d'une bascule D.

Sous le terme multiplexeur on désigne, dans la présente description, un multiplexeur ou tout autre dispositif qui possède une ou plusieurs entrées de signaux, une entrée de sélection et une sortie qui recopie la valeur d'une des entrées signaux en fonction de la valeur de la commande de sélection.

Les 3 bascules fonctionnent sur la même horloge $F_e$. Le circuit ainsi constitué est caractérisé, par exemple, par les équations suivantes :

$$Q1 = P1^*Q3 + Q2^*\overline{Q3}$$

$$Q2 = P2^*Q3 + \overline{Q2}^*\overline{Q3}$$

$$Q3 = \overline{Q1} * \overline{Q3}$$

Où * désigne un ET logique et + un OU logique

Le tableau 1 ci-après regroupe les valeurs de rang de division obtenus par le diviseur de la figure 1.

| P1 | P2 | Rang de division obtenu en fonction de P1 et P2 |
|----|----|-------------------------------------------------|
| 0 | 1 | Le circuit divise par 2 |
| 1 | 0 | Le circuit divise par 3 |
| 1 | 1 | Le circuit divise par 4 |

La figure 2 représente une variante de réalisation permettant de traiter le cas interdit où P1=P2=0.

Par rapport au diviseur de la figure 1, le diviseur comporte en plus, par exemple, 2 latchs $U_4$, $U_5$ et 2 multiplexeurs $M_4$, $M_5$, recevant respectivement les entrées INC1 et INC2 du diviseur. Les 2 latchs peuvent être remplacés par 2 bascules ou tout autre dispositif ayant la même fonction.

Le fonctionnement du diviseur est donné dans le tableau 2 ci-dessous.

| INC1 | INC2 | |
|------|------|--|
| 0 | 0 | Le circuit divise par 2 |
| 1 | 0 | Le circuit divise par 3 |
| 0 | 1 | Le circuit divise par 3 |
| 1 | 1 | Le circuit divise par 4 |

Pour ces deux modes de réalisation, l'une des bascules D commande le chargement des 3 bascules $U_1$, $U_2$, $U_3$ pendant une période de l'horloge $F_e$. Ce fonctionnement est optimum du point de vue du temps de positionnement pour les commandes P1 et P2 et l'élimination des faux cycles.

Une autre caractéristique du dispositif selon l'invention est que Q1 possède un état bas de durée égale à une seule période de $F_e$ pour les 3 rangs de division. Cet état bas est par exemple situé en fin de cycle de Q1. Cette caractéristique est exploitée lorsque ce circuit est employé comme diviseur de tête dans une chaîne de division en donnant une possibilité de sélection d'un seul front de la fréquence $F_e$ par cycle de sortie du diviseur de tête.

Selon une autre variante de réalisation, chaque bascule D est décomposée en au moins 2 latchs.

Une autre variante consiste à conserver les mêmes équations logiques donnant Q1, Q2 et Q3 qui sont caractéristiques du circuit et de leur appliquer des transformations logique usuelles. Un exemple de transformation consiste à complémenter les 2 parties de chaque équation.

Sans sortir du cadre de l'invention, toute bascule dont la sortie mémorise la valeur de l'entrée à l'instant de la transition d'horloge (front d'horloge positif ou négatif) peut être utilisée dans le diviseur selon l'invention.

**Revendications**

1. Dispositif pour diviser une fréquence $F_e$ **caractérisé en ce qu'**il comporte au moins les éléments suivants :

   ○ trois bascules ($U_1$, $U_2$, $U_3$), chacune des bascules recevant la fréquence $F_e$ à diviser, tout chemin de rebouclage entre une sortie d'une bascule et son entrée ou l'entrée des autres bascules comportent un seul multiplexeur ($M_1$, $M_2$, $M_3$), et **en ce que**
   ○ l'une des bascules commande le chargement de toutes les bascules ($U_1$, $U_2$, $U_3$) pendant une période de $F_e$.

2. Dispositif selon la revendication 1 **caractérisé en ce qu'**un multiplexeur comporte 2 entrées, 1 bit de sélection, 1 sortie et **en ce qu'**il est intégré à une bascule.

3. Dispositif selon l'une des revendications 1 ou 2 **caractérisé en ce qu'**il comporte 2 latchs ($U_4$, $U_5$) et 2 multiplexeurs ($M_4$, $M_5$), recevant respectivement les entrées INC1 et INC2 du diviseur.

**4.** Dispositif selon la revendication 3 **caractérisé en ce qu'**un multiplexeur est intégré à une bascule.

**5.** Dispositif selon l'une des revendications 1 ou 2 **caractérisé en ce qu'**il comporte deux bascules et 2 multiplexeurs ($M_4$, $M_5$), recevant respectivement les entrées INC1 et INC2 du diviseur.

**6.** Diviseur à 3 rangs de division 2/3/4 **caractérisé en ce qu'**il comporte un dispositif selon l'une des revendications 1 à 5.

**Claims**

**1.** Device for dividing a frequency $F_e$, **characterized in that** it comprises at least the following items:

○ three flip-flops ($U_1$, $U_2$, $U_3$), each of the flip-flops receiving the frequency $F_e$ to be divided, any loopback path between an output of a flip-flop and its input or the input of the other flip-flops including a single multiplexer ($M_1$, $M_2$, $M_3$), and **in that**
○ one of the flip-flops controls the loading of all the flip-flops ($U_1$, $U_2$, $U_3$) during a period of $F_e$.

**2.** Device according to Claim 1, **characterized in that** a multiplexer has two inputs, one select bit, one output and **in that** it is integrated in a flip-flop.

**3.** Device according to one of Claims 1 or 2, **characterized in that** it comprises two latches ($U_4$, $U_5$) and two multiplexers ($M_4$, $M_5$), respectively receiving the inputs INC1 and INC2 of the divider.

**4.** Device according to Claim 3, **characterized in that** a multiplexer is integrated in a flip-flop.

**5.** Device according to one of Claims 1 or 2, **characterized in that** it comprises two flip-flops and two multiplexers ($M_4$, $M_5$), respectively receiving the inputs INC1 and INC2 of the divider.

**6.** Divider with three division ranks 2/3/4, **characterized in that** it comprises a device according to one of Claims 1 to 5.

**Patentansprüche**

**1.** Vorrichtung zum Teilen einer Frequenz $F_e$, **dadurch gekennzeichnet, dass** sie mindestens die folgenden Elemente aufweist:

○ drei Kippstufen ($U_1$, $U_2$, $U_3$), wobei jede der Kippstufen die zu teilende Frequenz $F_e$ empfängt, wobei jeder Rückkopplungspfad zwischen einem Ausgang einer Kippstufe und ihrem Eingang oder dem Eingang der anderen Kippstufen einen einzigen Multiplexer ($M_1$, $M_2$, $M_3$) aufweist, und dass
○ eine der Kippstufen das Laden aller Kippstufen ($U_1$, $U_2$, $U_3$) während einer Periode von $F_e$ steuert.

**2.** Vorrichtung nach Anspruch 1, **dadurch gekennzeichnet, dass** ein Multiplexer 2 Eingänge, 1 Auswahlbit, 1 Ausgang aufweist, und dass er in eine Kippstufe integriert ist.

**3.** Vorrichtung nach einem der Ansprüche 1 oder 2, **dadurch gekennzeichnet, dass** sie 2 Latches ($U_4$, $U_5$) und 2 Multiplexer ($M_4$, $M_5$) aufweist, die die Eingänge INC1 bzw. INC2 des Teilers empfangen.

**4.** Vorrichtung nach Anspruch 3, **dadurch gekennzeichnet, dass** ein Multiplexer in eine Kippstufe integriert ist.

**5.** Vorrichtung nach einem der Ansprüche 1 oder 2, **dadurch gekennzeichnet, dass** sie zwei Kippstufen und 2 Multiplexer ($M_4$, $M_5$) aufweist, die die Eingänge INC1 bzw. INC2 des Teilers empfangen.

**6.** Teiler mit 3 Teilungsgraden 2/3/4, **dadurch gekennzeichnet, dass** er eine Vorrichtung nach einem der Ansprüche 1 bis 5 aufweist.

FIG.1

FIG.2